# EUROPEAN PATENT APPLICATION

(11) **EP 1 669 801 A2**
(43) Date of publication of application: **14.06.2006**
(21) Application number: 05025544.7
(22) Date of filing: 23.11.2005
(51) Int. Cl.: G03F 1/00, G06F 17/50

(54) **Data generating system, patterning data generating apparatus, method of generating patterning data and storage medium carrying patterning data**

(30) Priority: 07.12.2004 JP 2004354127; 07.12.2004 JP 2004354128; 07.12.2004 JP 2004354129
(71) Applicant: Dainippon Screen Mfg. Co., Ltd., Kyoto 602-8585 (JP)
(72) Inventor: Norihiko, Nakamura, c/o Dainippon Screen Mfg. Co., Horikawa-dori, Kamikyo-ku Kyoto 602-8585 (JP); Yoshihiro, Kishida, c/o Dainippon Screen Mfg. Co., Horikawa-dori, Kamikyo-ku Kyoto 602-8585 (JP)
(74) Representative: Kilian, Helmut

(57) **Abstract**

In a data generating system, a basic pattern generating part (2331) generates patterning data having a basic pattern data block into which basic pattern CAD data is converted and a correct rule adding part (3332) adds a correct rule obtained from a database (3142) on the basis of a rule adding index indicating a patterning condition and an object pattern element to the above patterning data as a correct rule data block, to automatically generate the patterning data. As a result, it is possible to increase the efficiency of designing a pattern as compared with a case where an operator corrects data indicating of each of pattern elements in the basic pattern data block one by one. It is further possible to easily make a change in basic structure of a pattern and a fine change of pattern in accordance with a patterning operation.

## Description

### BACKGROUND OF THE INVENTION

### Field of the Invention

The present invention relates to a data generating system for generating patterning data used for forming a geometric pattern on a substrate in manufacturing a printed circuit board, a semiconductor substrate, a flat panel display or the like, a patterning data generating apparatus, a method of generating patterning data and a storage medium carrying patterning data.

### Description of the Background Art

As a method of writing a geometric pattern by emitting light to a light-sensitive material formed on a printed circuit board, a semiconductor substrate, a flat panel display such as a plasma display or a liquid crystal display, a glass substrate for photomask, or the like (hereinafter, referred to as "substrate"), well known are a method for transferring a mask pattern to a light-sensitive material and a method for directly writing a pattern by scanning and emitting modulated light beams on a light-sensitive material.

In a case of TFT (Thin Film Transistor) panel for a liquid crystal display, for example, a mask is formed on the basis of patterning data indicating positions and shapes of pattern elements such as devices, wires and the like to constitute a pattern, and light is emitted through the mask onto a light-sensitive material coating a substrate, to write the pattern.

In a design of such a mask pattern, a basic pattern shape required to fully exert a predetermined performance is first designed and next, the basic pattern shape is corrected in accordance with properties of manufacturing facilities to design the pattern shape to be used for actual formation of a mask. Japanese Patent Application Laid Open Gazette No. 2001-125251, for example, discloses a technique to make corrections for the basic pattern shape in order to compensate for an optical proximity effect that a pattern written on a substrate is distorted by interference of lights passing adjacent areas in a mask in a design of a polygonal line pattern.

In such a design of pattern, sometimes the design of basic pattern shape is made in a design section and the design of pattern shape to be used in an actual manufacture is made in a manufacturing section, and therefore, there is a limit to improvement in design efficiency, such as an operation being duplicated due to this uncertain design part sharing in these sections. Further, since their purposes of design are different in these sections, it is hard to check whether or not the pattern shape which is finally designed in the manufacturing section satisfies the limitations in design of these sections.

The patterning data indicating the pattern shape which is finally designed only has information on positions and shapes of pattern elements such as devices, wires and the like but does not have any information on how the basic pattern shape is, why the correction is made, which of limitations in design or manufacture causes the correction or the like. Therefore, figures and documents used in a process of generating the patterning data are needed in order to get the information on the basic pattern shape, the limitations causing the correction or the like, and this increases time required to get information and inhibits mutual understanding in the design and manufacturing processes.

In making a new design of pattern, a design change or correction in design in accordance with properties of manufacturing facilities, not only longer time to get the information on design but also possible time for repeated trial and error consequently increase time for design. This makes it hard to achieve automation in design change or the like.

### SUMMARY OF THE INVENTION

The present invention is intended for a data generating system for generating patterning data used for forming a geometric pattern on a substrate in manufacturing a printed circuit board, a semiconductor substrate or a flat panel display, and it is a main object to increase the efficiency of designing a pattern and it is another object to easily change a design of pattern.

The present system is a data generating system for generating patterning data used for forming a geometric pattern on a substrate in manufacturing a printed circuit board, a semiconductor substrate or a flat panel display. The system comprises a basic pattern generating part for generating data indicating a basic pattern which is a group of pattern elements arranged on a substrate, to generate patterning data having the data as a basic pattern data block, and a correct rule adding part for adding a correct rule data block to the patterning data, the correct rule data block indicating a correct rule which is obtained in a patterning operation in accordance with the type of pattern element or the type of combination of pattern elements included in the basic pattern. By the system of the present invention, it is possible to increase the efficiency of designing a pattern and further possible to easily change a design of pattern.

According to one preferred embodiment of the present invention, the system further comprises a correct rule changing part for changing a correct rule indicated by the correct rule data block independently of the basic pattern data block. It is thereby possible to quickly respond to a change of manufacturing condition or the like by changing only the correct rule, without changing the basic pattern.

According to another preferred embodiment of the present invention, the correct rule data block is added by the correct rule adding part as a data block described in the patterning data, independently of the basic pattern data block. The basic pattern and the correct rule can be thereby easily distinguished from each other and it is therefore to quickly respond to a change of the correct rule.

According to still another preferred embodiment of the present invention, the system further comprises a storage part for storing a database which is a set of data elements each associating a correct rule with key information including the type of pattern element or the type of combination of pattern elements and a patterning condition and in the system, the correct rule adding part extracts a correct rule associated with key information including the type of pattern element or the type of combination of pattern elements included in the basic pattern and a patterning condition determined in advance from the database and adds the correct rule to the patterning data. It is thereby possible to reduce the time required to generate the correct rule data block.

According to an aspect of the present invention, the system is a data generating system for generating patterning data used for forming a geometric pattern on a substrate in manufacturing a printed circuit board, a semiconductor substrate or a flat panel display, and the system comprises a basic pattern generating apparatus managed by a design section for a pattern, for generating data indicating a basic pattern which is a group of pattern elements arranged on a substrate, to generate patterning data having the data as a basic pattern data block, and a patterning data generating apparatus managed by a patterning section for the pattern, for adding a correct rule data block to the patterning data received from the basic pattern generating apparatus through a communication network and generating data of a corrected pattern, and in the system, the basic pattern generating apparatus comprises a correct rule adding part for adding a correct rule data block to the patterning data, the correct rule data block indicating a correct rule which is obtained in a patterning operation in accordance with the type of pattern element or the type of combination of pattern elements included in the basic pattern, and a corrected data generating part for generating data of a corrected pattern for patterning, by specifying one out of pattern elements or combinations of pattern elements which are indicated by the basic pattern data block, which is associated with a correct rule indicated by the correct rule data block and correcting a specified pattern element or a specified combination of pattern elements in accordance with the correct rule.

The present invention is also intended for a patterning data generating apparatus for generating patterning data used for forming a geometric pattern on a substrate in manufacturing a printed circuit board, a semiconductor substrate or a flat panel display. The apparatus comprises a correct rule adding part for adding a correct rule data block to patterning data which has data indicating a basic pattern which is a group of pattern elements arranged on a substrate as a basic pattern data block, the correct rule data block indicating a correct rule which is obtained in a patterning operation in accordance with the type of pattern element or the type of combination of pattern elements included in the basic pattern, and a corrected data generating part for generating data of a corrected pattern for patterning, by specifying one out of pattern elements or combinations of pattern elements which are indicated by the basic pattern data block, which is associated with a correct rule indicated by the correct rule data block and correcting a specified pattern element or a specified combination of pattern elements in accordance with the correct rule. It is preferable that the apparatus further comprises an account information part for giving information to a predetermined accounting apparatus through a communication network when the corrected data generating part performs a correction.

The present invention is also intended for a method of generating patterning data used for forming a geometric pattern on a substrate in manufacturing a printed circuit board, a semiconductor substrate or a flat panel display, and a computer-readable storage medium carrying the patterning data.

These and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a view showing a construction of a data generating system in accordance with a first preferred embodiment;
Fig. 2 is a view showing a constitution of a patterning data generating apparatus;
Fig. 3 is a block diagram showing a functional constitution of a basic pattern generating apparatus and the patterning data generating apparatus;
Fig. 4 is a view showing a structure of a database;
Fig. 5 is a view showing a structure of a data element;
Figs. 6A and 6B are flowcharts showing operation flows of the data generating system;
Fig. 7 is a view showing a basic pattern;
Fig. 8 is a view showing basic pattern CAD data;
Figs. 9 and 10 are views showing patterning data;
Fig. 11 is a flowchart showing an operation flow for acquiring a correct rule;
Fig. 12 is a view showing a search key;
Fig. 13 is a view showing the patterning data;
Fig. 14 is a flowchart showing an operation flow for acquiring a correction value;
Fig. 15 is a view showing a relational database;
Fig. 16 is a view showing display data;
Fig. 17 is a view showing the basic pattern and a corrected pattern;
Fig. 18 is a view showing corrected data;
Fig. 19 is an enlarged view showing a pattern element of the basic pattern;
Fig. 20 is a view showing a correct rule data block;
Fig. 21 is a view showing a relational database;
Fig. 22 is a view showing polygonal lines and corrected polygonal lines;
Fig. 23 is a block diagram showing functions of a basic pattern generating apparatus in a data generating system in accordance with a second preferred embodiment together with other constitution;
Fig. 24 is a view showing a structure of a data element;
Fig. 25 is a flowchart showing part of an operation flow of the data generating system;
Fig. 26 is a view showing a patterning data; and
Fig. 27 is a block diagram showing a functional constitution of a data generating apparatus.

### DESCRIPTION OF THE PREFERRED EMBODIMENTS

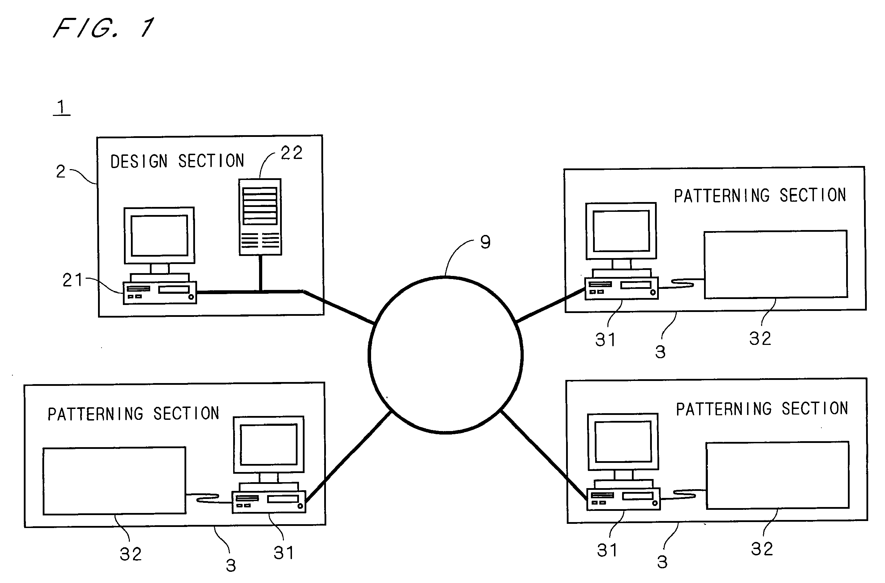

Fig. 1 is a view showing a construction of a data generating system 1 for generating patterning data in accordance with the first preferred embodiment of the present invention. The patterning data is used for in manufacturing a printed circuit board, a semiconductor substrate, a flat panel display such as a plasma display or a liquid crystal display, a glass substrate for photomask (hereinafter, referred to as "substrate"), for forming a geometric pattern on any one of these substrates.

The data generating system 1 has a construction in which a basic pattern generating apparatus 21 and a server 22 are provided in and managed by a design section 2 for designing a pattern and a patterning data generating apparatus 31 is provided in and managed by a patterning section 3 which is part of a manufacturing section and used for patterning and these constituent elements are connected to a communication network 9. Though the basic pattern generating apparatus 21 and the patterning data generating apparatus 31 are each shown as one computer in Fig. 1, for convenience of illustration, each of these apparatuses may be constituted of a plurality of computers. A plurality of basic pattern generating apparatuses 21 may be provided on the communication network 9.

In the patterning section 3, the patterning data generating apparatus 31 is connected to a patterning facility 32 used for patterning. The communication network 9 is an intracompany LAN, a WAN, the internet or the like, and in a case where communication is made on the internet, information to be transmitted is all coded. In the data generating system 1, use of the patterning data generating apparatus 31 in the patterning section 3 is charged and information on accounting is managed by the server 22 in the design section 2. In other words, the server 22 serves as an accounting apparatus in the data generating system 1. The design section 2 and the patterning section 3 may belong to a company or may belong to different companies.

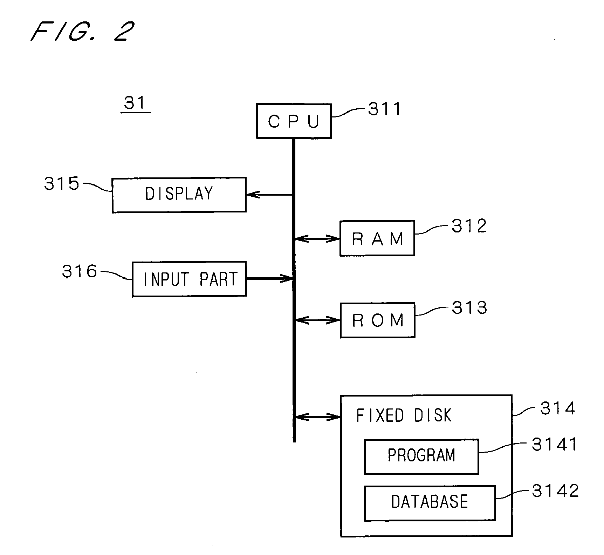

Fig. 2 is a view showing a constitution of the patterning data generating apparatus 31. The patterning data generating apparatus 31 has a construction, like a general-type computer, in which a CPU 311 for performing various computations, a RAM 312 storing programs to be executed and serving as a work area for various computations, a ROM 313 for storing a basic program, a fixed disk 314 for storing various information, a display 315 for displaying various information to an operator, and an input part 316 such as a keyboard and a mouse are all connected to one another. The fixed disk 314 stores a program 3141 to be executed by the patterning data generating apparatus 31 and a database 3142. In other words, the fixed disk 314 serves as a storage part for storing the database 3142. The basic pattern generating apparatus 21 is not shown as it has the same constitution as the patterning data generating apparatus 31 shown in Fig. 2, and comprises the CPU, the RAM, the ROM, the fixed disk, the display and the input part. The fixed disk in the basic pattern generating apparatus 21 stores no database which corresponds to the database 3142.

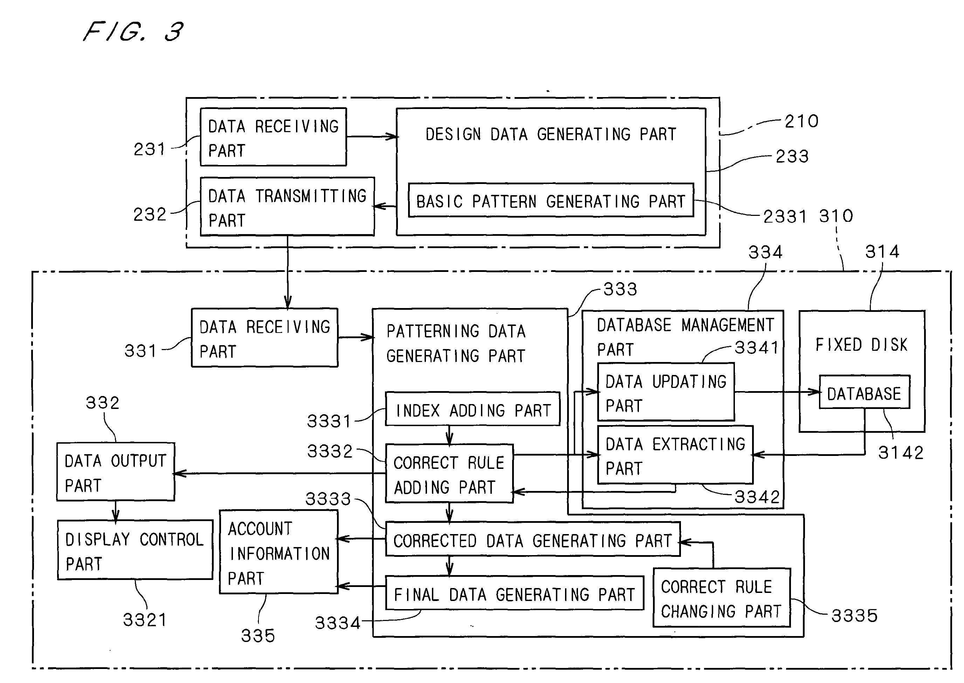

Fig. 3 is a block diagram showing functions implemented through computations performed by the CPUs and the like in the basic pattern generating apparatus 21 and the patterning data generating apparatus 31 (see Fig. 2) in accordance with the program stored in the fixed disk, together with other functional constitution. In Fig. 3, a block surrounded by the one-dot chain line 210 indicates a function inplemented by the basic pattern generating apparatus 21 in the design section 2 and a block surrounded by the two-dot chain line 310 indicates function and constitution of the patterning data generating apparatus 31 in the patterning section 3. In Fig. 3, a data receiving part 231, a data transmitting part 232 and a design data generating part 233 in the basic pattern generating apparatus 21 and a data receiving part 331, a data output part 332, a display control part 3321, a patterning data generating part 333, a database management part 334 and an account information part 335 in the patterning data generating apparatus 31 correspond to functions implemented by the CPUs and the like in these apparatuses.

In the data generating system 1, the patterning data is generated by these constituent elements. The patterning data includes a basic pattern which is a group of pattern elements (i.e., basic graphics such as circles and straight lines) arranged on a substrate (the basic pattern is a minimum pattern required for a predetermined use of the substrate), and a rule (hereinafter, referred to as "correct rule") for correcting the basic pattern obtained in an actual patterning operation in accordance with the type of pattern element or the type of combination of pattern elements included in the basic pattern.

The design data generating part 233 has a basic pattern generating part 2331 as a function implemented by the CPU and the like in the basic pattern generating apparatus 21, and the patterning data generating part 333 has an index adding part 3331, a correct rule adding part 3332, a corrected data generating part 3333, a final data generating part 3334 and a correct rule changing part 3335 as functions implemented by the CPU 311 and the like (see Fig. 2). The database management part 334 has a data updating part 3341 and a data extracting part 3342 as functions implemented by the CPU 311 and the like. Detailed description on these functions will be made later.

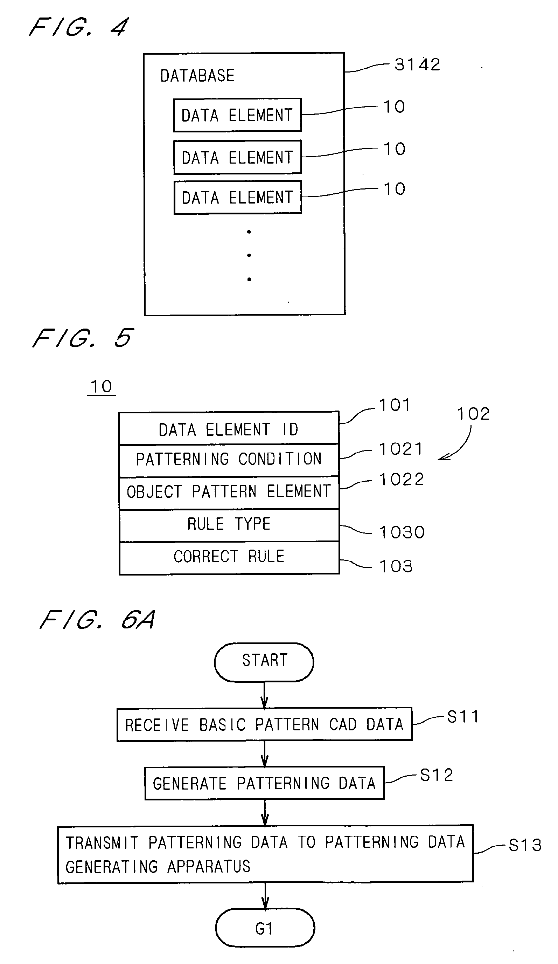

Fig. 4 is a view showing a structure of the database 3142 stored in the fixed disk 314 of the patterning data generating apparatus 31. The database 3142 is a set of the data elements 10 shown in Fig. 5, and each data element 10 includes a data element ID 101 for identification of the data element, key information 102 for retrieving data elements, a correct rule 103 associated with the key information 102 and a rule type 1030 which is an identifier indicating the type of correct rule 103. The key information 102 includes a patterning condition 1021 indicating various conditions on patterning which are determined in advance (typically, the type of patterning facility 32 (see Fig. 1)) and an object pattern element 1022 which is an identifier indicating the type of pattern element or the type of combination of pattern elements such as devices and wires in a pattern, to which the correct rule 103 is applied. The following discussion will be made assuming that the patterning condition 1021 is information indicating the type of patterning facility 32. The correct rule 103 is a rule determined from limitations in manufacture or the like intrinsic to a patterning section 3 and is individually managed by the patterning section 3.

The data receiving part 231 in the basic pattern generating apparatus 21 shown in Fig. 3 includes the input part such as a keyboard and a mouse to receive design data or the like, typified by CAD (Computer Aided Design) data indicating the shape of the basic pattern used for generating the patterning data, and the design data generating part 233 generates the patterning data from the CAD data received by the data receiving part 231. The data transmitting part 232 transmits the patterning data generated by the design data generating part 233 to the patterning data generating apparatus 31 through the communication network 9 (see Fig. 1).

The data receiving part 331 in the patterning data generating apparatus 31 receives the patterning data transmitted from the basic pattern generating apparatus 21, and the patterning data generating part 333 corrects the patterning data received by the data receiving part 331 and generates corrected data and final data. The patterning data or the like corrected by the patterning data generating part 333 is outputted by the data output part 332 and displayed on the display 315 (see Fig. 1) by the display control part 3321 as necessary.

The database management part 334 in the patterning data generating apparatus 31 extracts the correct rule to be used for correction of the patterning data performed by the patterning data generating part 333, from the database 3142 stored in the fixed disk 314, and outputs the extracted correct rule to the patterning data generating part 333. The database management part 334 updates the database 3142 in accordance with an input of the data element for update.

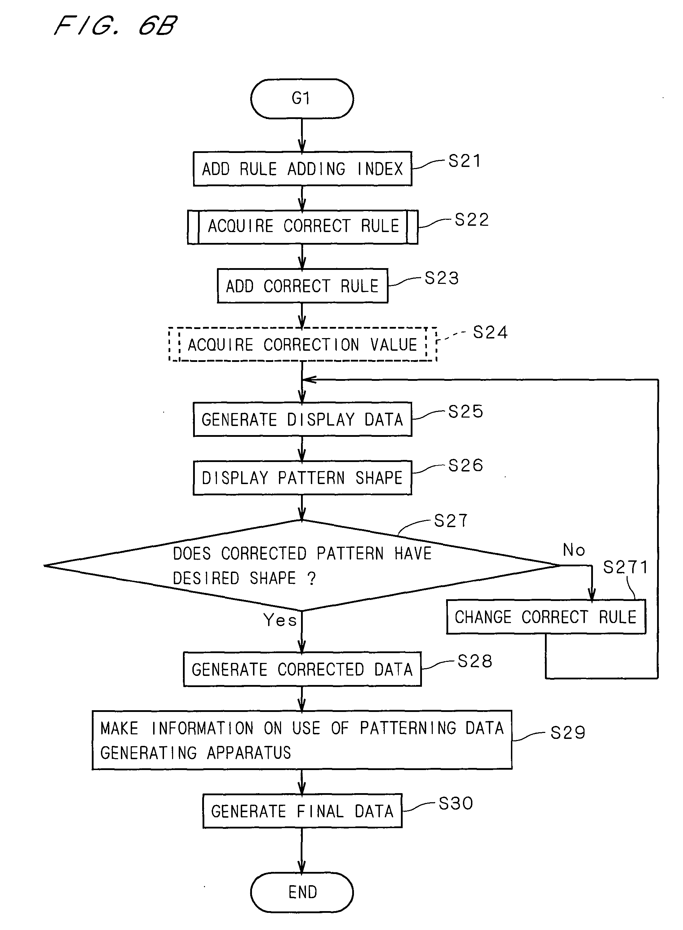

Figs. 6A and 6B are flowcharts showing operation flows of the data generating system 1 for generating the patterning data, the corrected data and the final data. The operation of the data generating system 1 in a specific case will be discussed below. The following discussion will be made with respect to one basic pattern generating apparatus 21, one server 22 and one patterning data generating apparatus 31 on the data generating system 1 of Fig. 1.

In the first exemplary case, with respect to a basic pattern having three electrodes and wires connecting these electrodes, discussion will be made on an operation flow for generating patterning data, corrected data and final data with width compensation of wires, in consideration of thinning of the wires in actual patterning performed on a substrate by etching (a phenomenon that the width of a wire which is formed on a substrate becomes thinner than the designed width of the wire which is inputted to facilities for performing the etching in accordance with properties of the facilities or the like).

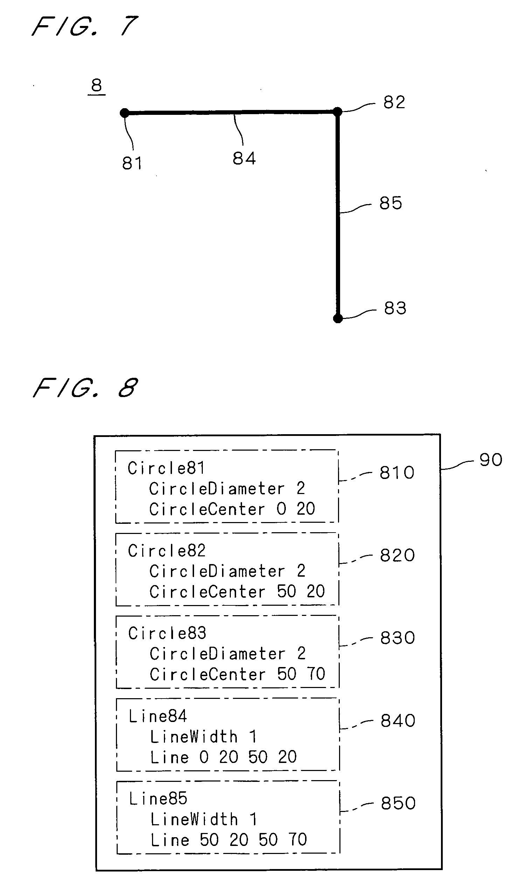

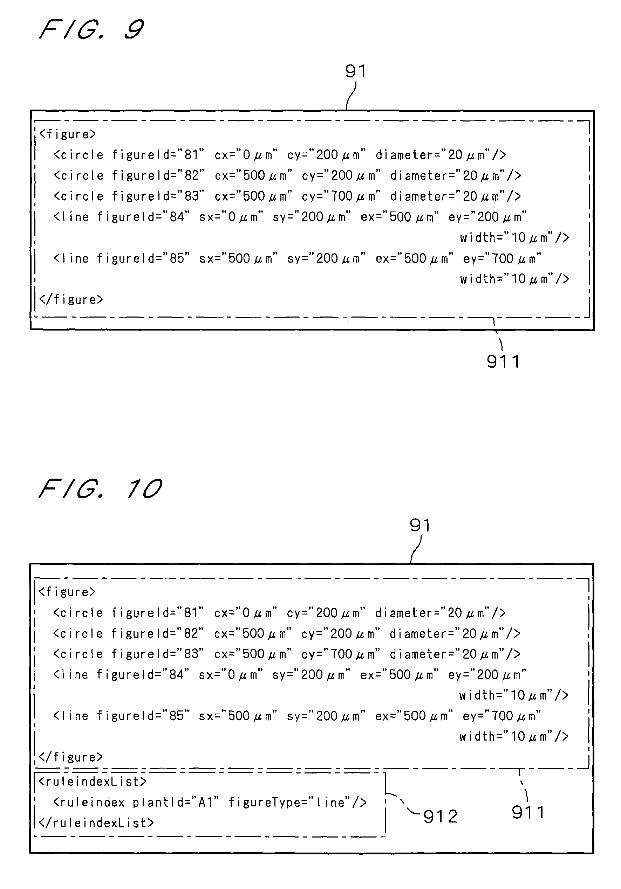

Fig. 7 is a view showing a basic pattern 8 which is a base of patterning data generated by the data generating system 1, and Fig. 8 is a view showing CAD data (hereinafter, referred to as "basic pattern CAD data") 90 indicating the shape of the basic pattern 8. As shown in Fig. 7, the basic pattern 8 has circles 81 to 83 representing electrodes and straight lines 84 and 85 representing wires connecting the electrodes as pattern elements. Both ends of the straight line 84 are the circles 81 and 82 and both ends of the straight line 85 are circles 82 and 83. In the basic pattern CAD data 90 of Fig. 8, blocks surrounded by one-dot chain lines 810 to 850 indicate the circles 81 to 83 and the straight lines 84 and 85 in a vector graphics form, respectively.

Though a simple basic pattern 8 is shown in Fig. 7 for easy understanding, a basic pattern 8 may have not only circles and straight lines but also other basic graphics such as points, polygons, polygonal lines, spline curves and bezier curves as pattern elements. In the basic pattern CAD data 90 of Fig. 8, these pattern elements may be represented in a vector graphics form or represented as data indicating addresses for other graphics files, image data or the like which are external references.

The basic pattern CAD data 90 may include data indicating detailed specification of each pattern element (e.g., geometry handling of bend of a polygonal line, line widths of start point and end point of graphics in a case of gradual change in line width of graphics, and enlargement, reduction or rotation of a pattern element), data indicating relation among layers in which pattern elements are written, data indicating an effective area (only the pattern elements present in this area are used as elements constituting a pattern) in a coordinate space where pattern elements are written, or the like (which are data associated with the pattern element and hereinafter, referred to as "associated data"). Alternatively, these associated data may be handled as other data associated with the basic pattern CAD data 90. The basic pattern CAD data 90 may be described in a format other than the description format shown in Fig. 8 (e.g., gerber format, GDS II , or the like).

In generation of patterning data performed by the data generating system 1, first, the basic pattern CAD data 90 is received by the data receiving part 231 in the basic pattern generating apparatus 21 shown in Fig. 3 and transmitted to the design data generating part 233 (Step S11). Subsequently, the basic pattern generating part 2331 of the design data generating part 233 converts the description format of the basic pattern CAD data 90 into XML (Extensible Markup Language), to generate patterning data 91 having a basic pattern data block 911 indicating the basic pattern 8 as shown in Fig. 9 (Step S12). In Fig. 9, a declaration data block and a document type declaration data block of a version and the like of XML are not shown (the same applies to the following figures).

As shown in Fig. 9, the circles 81 to 83 of Fig. 7 are each defined with element name "circle" and have attributes such as "figureId" for identifying the pattern element, "cx" and "cy" indicating an X-coordinate value and a Y-coordinate value of its center, respectively, and "diameter" for its diameter. The straight lines 84 and 85 are each defined with element name "line" and have attributes such as "figureId" for identifying the pattern element, "sx" and "sy" indicating an X-coordinate value and a Y-coordinate value of its start point and "ex" and "ey" indicating an X-coordinate value and a Y-coordinate value of its end point, respectively, and "width" for its line width.

The patterning data 91 generated by the basic pattern generating part 2331 of Fig. 3 is transmitted by the data transmitting part 232 in the basic pattern generating apparatus 21 to the patterning data generating apparatus 31 through the communication network 9 (see Fig. 1) (Step S13). In the patterning data generating apparatus 31, the patterning data 91 indicating only the basic pattern is received by the data receiving part 331 and transmitted to the patterning data generating part 333.

After the patterning data 91 is transmitted to the patterning data generating part 333, a patterning condition indicating the type of the patterning facility 32 (see Fig. 1) and an object pattern element indicating the type of pattern element or the type of combination of pattern elements to which the correct rule is applied are received by the data receiving part 331 of the patterning data generating apparatus 31 and transmitted to the patterning data generating part 333. These data are data to be used for adding the correct rule to the basic pattern data block 911, and hereinafter, referred to as "rule adding index".

Subsequently, as shown in Fig. 10, the index adding part 3331 adds the rule adding index 912 to the patterning data 91 (Step S21). In the rule adding index 912 described in XML, the patterning facility 32 whose "plantId" is "A1" is specified as the patterning condition and the pattern element whose "figureType" is "line" is specified as the object pattern element. In the patterning data generating apparatus 31, on the basis of the rule adding index 912 which is added to basic pattern data block 911, the correct rule adding part 3332 acquires the correct rule from the database 3142 (Step S22).

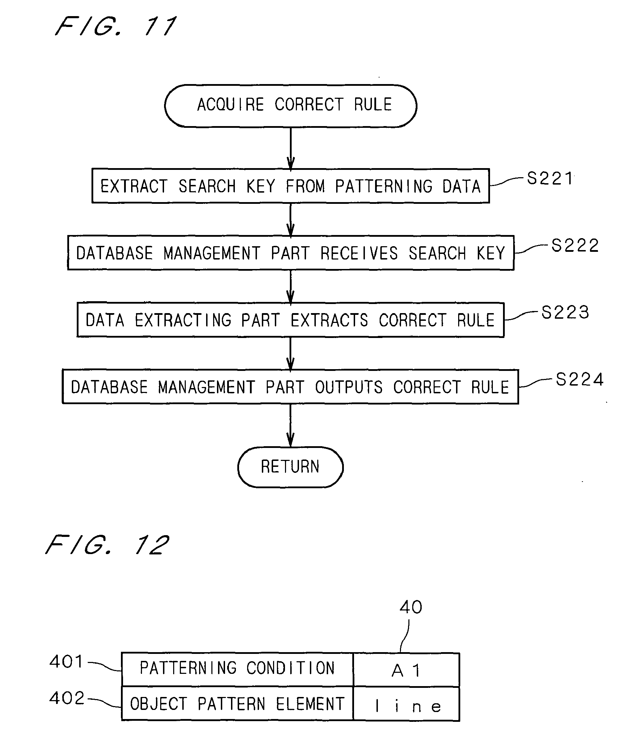

Fig. 11 is a flowchart showing an operation flow of the patterning data generating apparatus 31 for acquiring the correct rule in Step S22. Fig. 12 is a view showing a search key 40 used for acquiring the correct rule. In acquiring the correct rule, first, the correct rule adding part 3332 of the patterning data generating part 333 (see Fig. 3) extracts the patterning condition 401 ("plantId" = "A1") and the object pattern element ("figureType" = "line") from the rule adding index 912 (see Fig. 10) and these data serves as the search key 40 of Fig. 12 (Step S221).

The search key 40 extracted by the correct rule adding part 3332 is received by the database management part 334 of Fig. 3 and transmitted to the data extracting part 3342 (Step S222). Subsequently, the database 3142 is searched on the basis of the search key 40, and a correct rule 103 and a rule type 1030 which are associated with the key information 102 (see Fig. 5) including the search key 40 is extracted by the data extracting part 3342 from the database 3142 (Step S223). The extracted correct rule 103 and rule type 1030 are outputted to the correct rule adding part 3332 of the patterning data generating part 333 by the database management part 334, to complete acquisition of the correct rule 103 (Step S224). The correct rule 103 which is acquired thus is a correct rule 103 intrinsic to the patterning facility 32 used for the patterning.

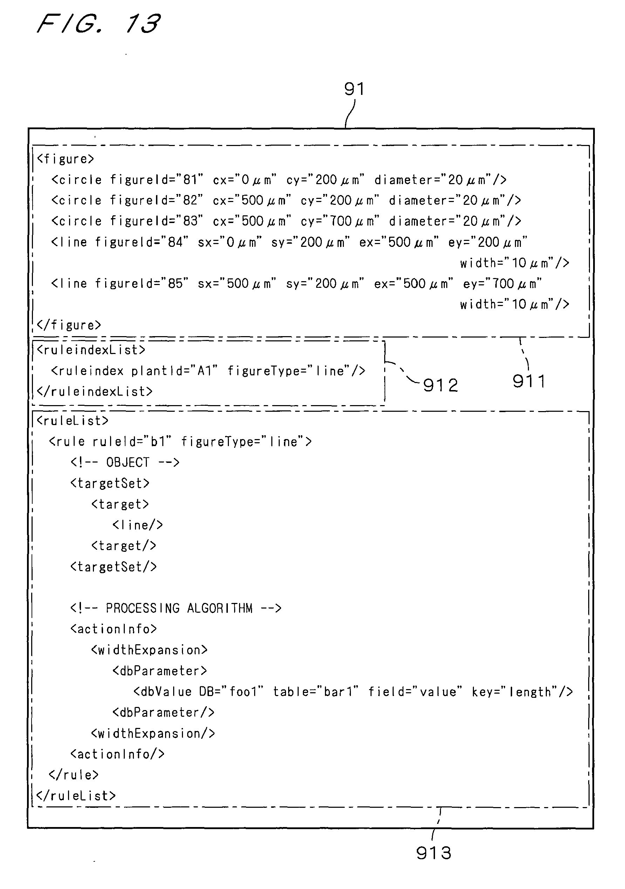

After the acquisition of the correct rule 103 of Fig. 5 is completed, the acquired correct rule 103 is added, together with the corresponding rule type 1030 and object pattern element 1022, to the patterning data 91 as the correct rule data block 913 by the correct rule adding part 3332 as shown in Fig. 13 (Fig. 6B: Step S23). In the patterning data 91, the correct rule data block 913 having the rule type 1030 and the object pattern element 1022 as attributes (i.e., "ruleId" and "figureType") is added as a data block which is described, being separated from the basic pattern data block1 911 and the rule adding index 912 (in the state where the correct rule data block 913 has no mutual inclusion relation with the basic pattern data block 911 and the rule adding index 912). In the patterning data 91, the correct rule data block 913 is described in XML like the basic pattern data block 911 and the rule adding index 912. If the patterning data 91 includes a plurality of basic pattern data blocks 911, rule adding indexes 912 and correct rule data blocks 913, these data blocks may be described alternately. The correct rule included in the correct rule data block 913 is not necessarily limited to the correct rule intrinsic to the patterning facility, but may be, for example, a design rule in designing the basic pattern 8, which is unaffected by the properties of the facilities, a manufacture rule common to the facilities in patterning an actual pattern on a substrate, or the like.

As shown in Fig. 13, the correct rule data block 913 includes the correct rule 103 whose "ruleId" indicating the rule type is "b1" and "figureType" indicating the type of object pattern element is "line" (hereinafter, using the value of "ruleId", this correct rule is referred to as "correct rule b1"). The correct rule b1 is a rule for correction of the width of a wire in accordance with the length of a wire in a pattern, which is represented by a straight line.

After the correct rule data block 913 is added to the patterning data 91, a correction value to be used for correction as necessary is acquired by the corrected data generating part 3333 (see Fig. 3), which generates data of a corrected pattern for patterning (hereinafter, referred to as "corrected data") through correction of the basic pattern data block 911 (Step S24). Fig. 14 is a flowchart showing an operation flow for acquiring the correction value (in other words, a correction width of the wire). First, some out of the pattern elements or combinations of the pattern elements indicated by the basic pattern data block 911 in the patterning data 91, which correspond to the correct rule b1 indicated by the correct rule data block 913, specifically, the straight lines 84 and 85 (see Fig. 7) which are pattern elements indicated by the attribute "figureType" of the correct rule b1, are specified as objects for correction (Step S241). Subsequently, a processing algorithm of the correct rule b1 is applied to acquire the respective lengths of the straight lines 84 and 85 from the coordinate values of start points and end points (Step S242).

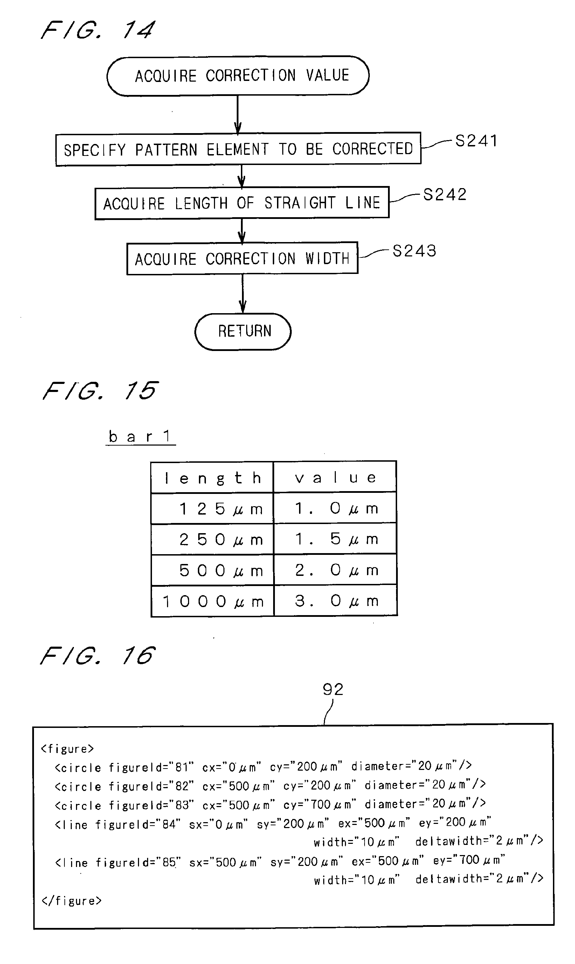

Fig. 15 is a view showing a table bar1 of a relational database foo1 associated with the correct rule b1 and/or the patterning condition (i.e., the patterning facility 32 whose "plantId" is "A1"). The corrected data generating part 3333 acquires the correction width ("value") of the wire represented by the straight line 84 as "dbValue" in the correct rule data block 913 (see Fig. 13) on the basis of the length of the straight line 84 obtained in Step S242 and the table bar1 of Fig. 15 (the same applies to the straight line 85) (Step S243). If the correction value is described in the correct rule in advance, the Step S24 is not executed.

After the correction width is acquired, the corrected data generating part 3333 corrects the parts of the basic pattern data block 911 which indicate the straight lines 84 and 85 in accordance with the correct rule b1, to generate data 92 of the corrected pattern for display (hereinafter, referred to as "display data 92") shown in Fig. 16 (Fig. 6B: Step S25). As shown in Fig. 16, in the display data 92, the correction width (the value represented by "deltawidth" in Fig. 16) acquired in accordance with the correct rule b1 is added to each of the parts of the basic pattern data block 911 in the patterning data 91 which indicate the straight lines 84 and 85, distinguishably from the original widths of the straight lines 84 and 85 (the values represented by "width" in Fig. 16). The display data 92 is described in XML like the patterning data 91. A substantial part of the correction algorithm for the basic pattern data block 911 in accordance with the correct rule is not shown.

In the patterning data generating apparatus 31, the display data 92 generated by the corrected data generating part 3333 of Fig. 3 is transmitted from the patterning data generating part 333 to the data output part 332 and its pattern shape is displayed on the display 315 (see Fig. 2) by the data output part 332 (Step S26). Fig. 17 is an enlarged view showing part of the pattern displayed on the display 315. In the patterning data generating apparatus 31, with the output of the data output part 332 controlled by the display control part 3321, as shown in Fig. 17, the basic pattern 8 (the circle 82 and the straight lines 84 and 85 in Fig. 17), the corrected pattern 8a (the circle 82 and straight lines 84a and 85a in Fig. 17) and the difference 8b between the basic pattern 8 and the corrected pattern 8a (which corresponds to portions hatched in the Fig. 17 and is hereinafter, referred to as "the amount of correction") are displayed on the display 315. Either one of the basic pattern 8 and the corrected pattern 8a may be selectively displayed.

When the pattern is displayed on the display 315, an operator checks appearances of the basic pattern 8, the corrected pattern 8a and the amount of correction 8b (Step S27). If the corrected pattern 8a does not have a desired shape, data for changing the amount of correction (hereinafter, referred to as "changing data") is received by the data receiving part 331 of Fig. 3 and transmitted to the patterning data generating part 333. In the patterning data generating part 333, the correct rule changing part 3335 changes the correct rule data block 913 of the patterning data 91 on the basis of the changing data, independently of the basic pattern data block 911 (Step S271). Specifically, the correction width acquired in Step S24 is changed into a new correction width indicated by the changing data. After the correct rule indicated by the correct rule data block 913 is changed, going back to Step S25, the display data 92 is generated again and the basic pattern 8, the corrected pattern 8a and the amount of correction 8b are displayed on the display 315 (Steps S25 and S26). Depending on the content of the changing data, in Step S271, there may be a change where a new correct rule is acquired from the database 3142 and the correct rule in the correct rule data block 913 is replaced by the new correct rule, or the like.

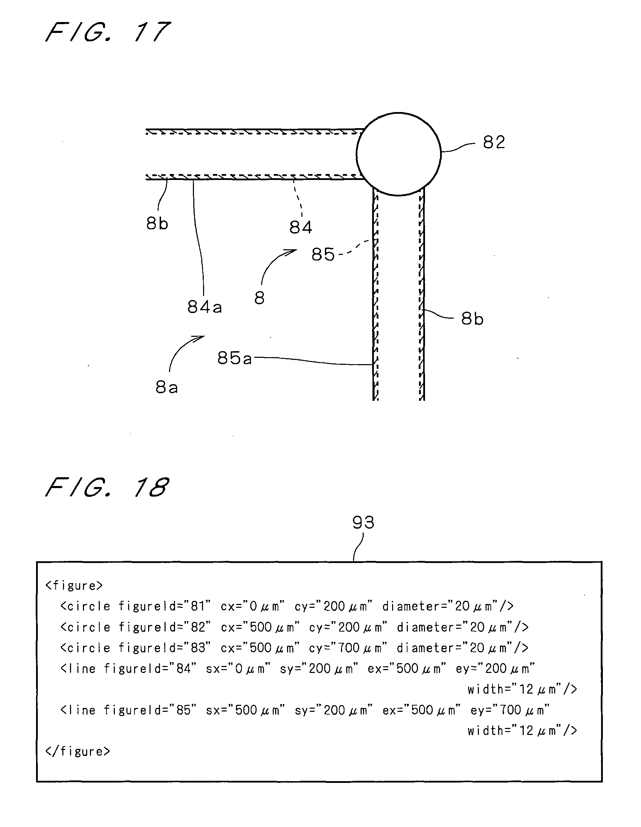

When the corrected pattern 8a gets the desired shape (Step S27), the parts in the basic pattern data block 911 which indicate the straight lines 84 and 85 which are the pattern elements specified as objects for correction are collectively corrected in accordance with the correct rule of the correct rule data block 913, to generate the corrected data 93 shown in Fig. 18 (Step S28). As shown in Fig. 18, the corrected data 93 is generated as data indicating a result of correction on the data indicating the straight lines 84 and 85 in the basic pattern data block 911 in accordance with the correct rule b1. In other words, in the corrected data 93, the shapes of the pattern elements are described with the basic shapes (the shapes represented as the basic pattern 8) and the corrected parts in accordance with the correct rule not distinguished from each other. The corrected data 93 is described in XML.

In the patterning data generating apparatus 31, when the corrected data generating part 3333 of Fig. 3 performs correction of the patterning data 91 to generate the corrected data 93, the corrected data generating part 3333 transmits a predetermined signal to the account information part 335. Then, the account information part 335 which receives the signal transmits information that the patterning data generating apparatus 31 was used to the server 22 in the design section 2 (see Fig. 1) through the communication network 9 (Step S29). The server 22 updates accounting information on use of the patterning data generating apparatus 31 in the patterning section 3, on the basis of the information from the account information part 335.

In the patterning data generating apparatus 31, the final data is generated by the final data generating part 3334 on the basis of the corrected data 93 (Step S30). The information on use of the patterning data generating apparatus 31 which is made by the account information part 335 may be given in generation of the final data, instead of or besides in generation of the corrected data 93. In such a case, like in the above case, the final data generating part 3334 transmits a predetermined signal to the account information part 335 when the final data is generated, and the account information part 335 gives the information on use of the patterning data generating apparatus 31 to the server 22 through the communication network 9.

The final data generated by the final data generating part 3334 is transmitted to the patterning facility 32 (see Fig. 1), and an actual pattern is formed on a substrate in the later process step. Patterning is performed on the basis of the final data generated through correction of the basic pattern 8 for compensating the widths of wires. As a result, thinning of the wires due to the properties of the facilities or the like is prevented and an appropriate pattern can be formed.

In the data generating system 1, with respect to the rule adding index 912 to be added to the patterning data 91 in Step S21 of Fig. 6B, a plurality of types of pattern elements may be specified as object pattern elements, respectively, and a plurality of combinations of pattern elements may be specified as object pattern elements. In Steps S22 and S23, a plurality of types of correct rules may be acquired from the database 3142 and added to the patterning data 91 as the correct rule data block 913. It is not always necessary to perform correction of the basic pattern data block 911 collectively in generation of the corrected data 93 in Step S28, and the correction may be performed in generation of the final data in Step S30 if can be done more efficiently. In such a case, the corrected data 93 has the correct rule concerned with some corrections performed in generation of the final data as the correct rule data block 913.

In the data generating system 1, an update of the database 3142 is made as necessary in a case of pattern design for a substrate on which a patterning is planed to be performed by new facilities or the like. In the update of the database 3142, after a prototype is made and so on, update data is inputted by the input part 316 (see Fig. 2) and transmitted to the data updating part 3341 of the database management part 334 shown in Fig. 3. Subsequently, the data updating part 3341 searches the database 3142 on the basis of the update data, and the update data is added as a new data element or already-existing data element is updated on the basis of the update data.

As discussed above, in the data generating system 1, the patterning data 91 including the basic pattern data block 911 which is generated by the basic pattern generating apparatus 21 managed by the design section 2 is transmitted to the patterning section 3 and the correct rule data block 913 including the correct rule which corresponds to the patterning condition (e.g., the type of patterning facility 32) intrinsic to the patterning section 3 and the object pattern element is added to the basic pattern data block 911 by the patterning data generating apparatus 31 managed by the patterning section 3, to automatically generate the patterning data 91 including the correct rule data block 913. Since the generated patterning data 91 comprises the basic pattern data block 911 and the correct rule data block 913, it is possible to individually specify the basic pattern and the correct rule for patterning. As a result, it is possible to increase the efficiency of designing a pattern, as compared with the case where an operator corrects data indicating each pattern element in the basic pattern data block 911 one by one. It is further possible to easily make a change in basic structure of a pattern (i.e., the basic pattern 8) and a fine change of pattern in accordance with a patterning operation.

In the patterning data generating apparatus 31, since the correct rule data block 913 is added to the patterning data 91 as a data block described separately from the basic pattern data block 911, it is possible to easily distinguish the basic pattern data block 911 and the correct rule data block 913 and quickly respond to a change of the correct rule. In the correct rule data block 913, since an identifier indicating the rule type and the type of object pattern element is given to each correct rule, even if a plurality of correct rules are included in the correct rule data block 913, it is possible to efficiently retrieve the correct rule to be changed in a change operation of the correct rule. This makes it possible to quickly respond to a pattern change due to a change in manufacturing condition or the like. The identifier given to each correct rule in the correct rule data block 913 may be any one of the rule type, the type of pattern element or combination of pattern elements to be corrected.

In the patterning data generating apparatus 31 of the data generating system 1, since the correct rule data block 913 can be changed by the correct rule changing part 3335 independently of the basic pattern data block 911, by changing only the correct rule without changing the basic pattern, it is possible to quickly respond to a change in manufacturing condition or the like. By changing the correct rule in the correct rule data block 913, which is intrinsic to the patterning facility, it is possible to generate the patterning data appropriate to each of facilities without changing the basic pattern.

In the patterning data generating apparatus 31, since the correct rule to be used for correction of the basic pattern is extracted from the database 3142 by the correct rule adding part 3332, it is possible to reduce the time required for generation of the correct rule data block 913 and this consequently achieves reduction in time required for generation of the patterning data 91. In the corrected data generating part 3333, by specifying the pattern element or the combination of pattern elements corresponding to the correct rule of the correct rule data block 913 out of the basic pattern data block 911 and correcting the specified pattern element or combination in accordance with the correct rule, it is possible to quickly perform automatic generation of the corrected data 93. Thus, in the patterning data generating apparatus 31, it is possible to easily generate the corrected data 93 which is data of a pattern corrected in accordance with the patterning condition or the like and increase the efficiency of designing a pattern.

In the patterning data generating apparatus 31, since the basic pattern, the corrected pattern and the amount of correction which indicates the difference between the basic pattern and the corrected pattern are displayed on the display 315 by the data output part 332, it is possible to easily grasp the difference in pattern shape before and after correction. As a result, it is possible to easily check the pattern shape after the correction.

In the data generating system 1, since the basic pattern data block 911, the rule adding index 912 and the correct rule data block 913 in the patterning data 91 are described in the same description language, handling of the patterning data 91 becomes easier. Since XML particularly has a wide range of adaptable description formats and is excellent in adaptability to data communication or the like, XML is suitable for description of the patterning data 91. The patterning data 91 may be described in PDF (Portable Document Format) which has a wide range of adaptable description formats and is excellent in adaptability to data communication or the like, as well as XML.

In the patterning data generating apparatus 31 of the data generating system 1, when the patterning data 91 is corrected by the corrected data generating part 3333 and/or the final data is generated by the final data generating part 3334 on the basis of the corrected data 93, the information that the patterning data generating apparatus 31 was used is made by the account information part 335. As a result, use of the patterning data generating apparatus 31 is appropriately charged.

In the data generating system 1, since the final data can be acquired in the patterning section 3 without openly informing the design section 2 of the patterning condition such as the properties of the patterning facility 32, in a case where the design section 2 and the patterning section 3 are different companies, or the like, it is possible to protect an outflow of information on the patterning facility 32 of the patterning section 3 or the like outside the company. In a case where an outsider who does not belong to customers gets the patterning data 91 generated in the design section 2, or the like, since he can not get the final data without using the patterning data generating apparatus 31, it is possible to improve the confidentiality of design information on patterning.

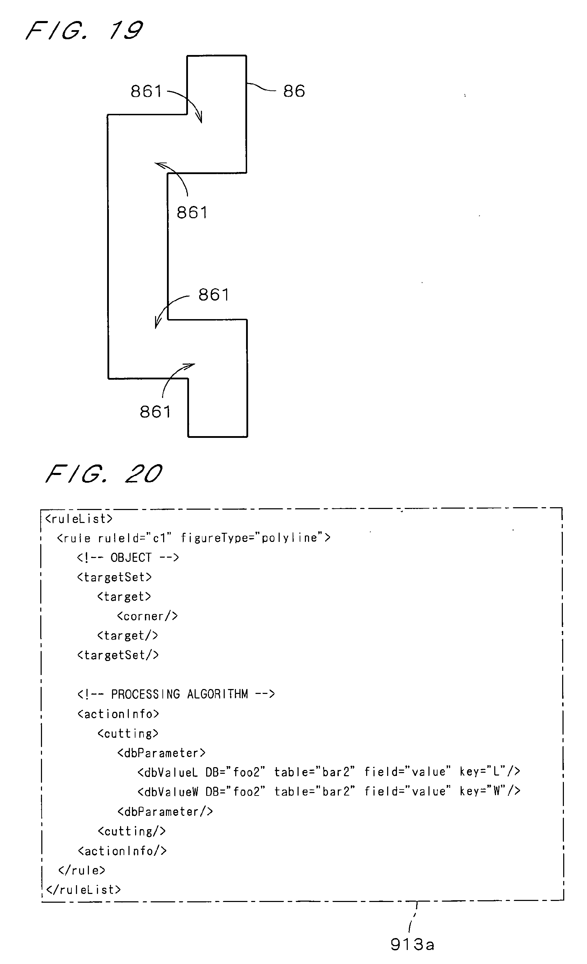

Next, referring to Fig. 19 and other figures, discussion will be made on a second exemplary case of generation of the patterning data, the corrected data and the final data by the data generating system 1. Fig. 19 is an enlarged view showing a polygonal line 86 which is one of pattern elements of the basic pattern which is a base of the patterning data. In the data generating system 1, on the basis of the basic pattern including the polygonal line 86, the patterning data of a photomask used for patterning on a semiconductor substrate is generated. A portion on the photomask which corresponds to the polygonal line 86 is a light transmission area, and a pattern of gate electrode is written on a resist layer on the semiconductor substrate with light passing the photomask. The straight line elements constituting the polygonal line 86 meet at right angles to one another

As shown in Fig. 19, since the polygonal line 86 has a plurality of bends 861, if the light transmission area of the photomask is formed in this shape, there arises an optical proximity effect, in a neighborhood of the bends 861, that a pattern written on a substrate is distorted by interference of lights passing the light transmission areas which are adjacent to one another. In the data generating system 1, the operations in Steps S11 to S30 of Figs. 6A and 6B are performed for the CAD data of the basic pattern including the polygonal line 86, to generate the patterning data, the corrected data and the final data on which correction for suppressing the optical proximity effect is made. Hereafter, discussion will be made on an operation of the data generating system 1.

In the data generating system 1, first, the basic pattern CAD data indicating the shape of the polygonal line 86 in a vector graphics form is received by the data receiving part 231 of the basic pattern generating apparatus 21 shown in Fig. 3 and transmitted to the design data generating part 233 (Step S11). Subsequently, the basic pattern generating part 2331 generates the patterning data described in XML from the basic pattern CAD data (Step S12), and the data transmitting part 232 of the basic pattern generating apparatus 21 transmits the patterning data to the patterning data generating apparatus 31 through the communication network 9 (see Fig. 1) (Step S13). In the following discussion, other data are also described in XML.

In the patterning data generating apparatus 31, the patterning data is received by the data receiving part 331 and transmitted to the patterning data generating part 333, and the rule adding index is added to the patterning data by the index adding part 3331 (Step S21). Subsequently, on the basis of the rule adding index added to the patterning data, the correct rule is acquired from the database 3142 by the correct rule adding part 3332 (Step S22) and the acquired correct rule is added to the patterning data as a correct rule data block 913a shown in Fig. 20 (Step S23).

As shown in Fig. 20, the correct rule data block 913a includes the correct rule whose "ruleId" indicating the rule type is "c1" and "figureType" indicating the type of object pattern element is "polyline" (polygonal line) (hereinafter, using the value of "ruleId", this correct rule is referred to as "correct rule c1"). The correct rule c 1 is a rule for correction to suppress the optical proximity effect on a bend ("corner") of the pattern element, represented by a polygonal line.

After the correct rule data block 913a is added to the patterning data, the corrected data generating part 3333 specifies one out of pattern elements or combinations of pattern elements indicated by the basic pattern data block of the patterning data, which corresponds to the correct rule c1 indicated by the correct rule data block 913a, i.e., a polygonal line 86 (see Fig. 18) which is a pattern element represented by the attribute "figureType" of the correct rule c1. Subsequently, the bends 861 of the polygonal line 86 are specified as objects for correction from the coordinate values of the polygonal line 86 indicated by the basic pattern data block, or the like.

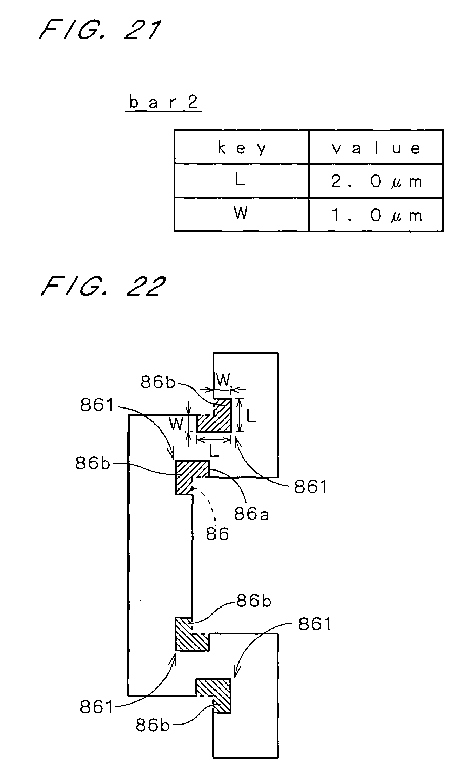

Fig. 21 is a view showing a table bar2 of a relational database foo2 associated with the correct rule c1 and/or the patterning condition of the rule adding index. The corrected data generating part 3333 acquires the correction length and the correction width ("value") as "dbValueL" and "dbValueW" in the correct rule data block 913a on the basis of keys "L" and "W" of Fig. 20 and the table bar2 of Fig. 21 (Step S24).

After the correction length and the correction width are acquired, the corrected data generating part 3333 corrects a part of the basic pattern data block of the patterning data which indicates the polygonal line 86 in accordance with the correct rule c1, to generate the display data (Step S25). On the basis of the display data, a pattern shape shown in Fig. 22 is displayed on the display 315 of the patterning data generating apparatus 31 (see Fig. 2) (Step S26). In the patterning data generating apparatus 31, as shown in Fig. 22, the polygonal line 86, a corrected polygonal line 86a and the difference 86b between the polygonal line 86 and the corrected polygonal line 86a (which corresponds to hatched portions in the Fig. 22 and is hereinafter, referred to as "the amount of correction") are displayed on the display 315. The length and width of the amount of correction 86b, represented by reference signs "L" and "W" in Fig. 22, are the correction length and the correction width, respectively, acquired in Step S24. Either one of the polygonal line 86 and the corrected polygonal line 86a may be selectively displayed.

When the pattern is displayed on the display 315, an operator checks appearances of the polygonal line 86, the corrected polygonal line 86a and the amount of correction 86b (Step S27). If the corrected polygonal line 86a does not have a desired shape, the changing data is received by the data receiving part 331 in the patterning data generating apparatus 31 and the correct rule data block 913a of the patterning data shown in Fig. 20 is changed by the correct rule changing part 3335 independently of the basic pattern data block (Step S271). After the correct rule indicated by the correct rule data block 913a is changed, going back to Step S25, the display data is generated again and the polygonal line 86, the corrected polygonal line 86a and the amount of correction 86b are displayed on the display 315 (Steps S25 and S26).

When the polygonal line 86a gets the desired shape (Step S27), the part in the basic pattern data block which indicates the polygonal line 86 is collectively corrected in accordance with the correct rule of the correct rule data block 913a, to generate the corrected data (Step S28). Then, the account information part 335 transmits information that the patterning data generating apparatus 31 was used to the server 22 in the design section 2 (see Fig. 1) through the communication network 9 (Step S29). The server 22 updates accounting information on use of the patterning data generating apparatus 31 in the patterning section 3, on the basis of the information from the account information part 335.

In the patterning data generating apparatus 31, the final data is generated by the final data generating part 3334 on the basis of the corrected data (Step S30). The information on use of the patterning data generating apparatus 31 which is made by the account information part 335 may be given in generation of the final data, instead of or besides in generation of the corrected data 93.

After that, the final data is transmitted to the patterning facility 32 (see Fig. 1), and a pattern is formed on a substrate in the later process step. Patterning is performed on the basis of the final data generated through correction of the bends 861 of the polygonal line 86 for suppressing the optical proximity effect. As a result, distortion of the bends in the pattern due to interference of lights is suppressed and an appropriate pattern can be formed.

As discussed above, in the data generating system 1, like in the first exemplary case, the patterning data 91 in which the correct rule data block 913a is added to the basic pattern data block 911 is automatically generated. In the patterning data 91, since the basic pattern and the correct rule for patterning can be individually specified, it is possible to increase the efficiency of designing a pattern, as compared with the case where an operator corrects data indicating each pattern element in the basic pattern data block 911 one by one. It is further possible to easily make a change in basic structure of a pattern (i.e., the basic pattern 8) and a fine change of pattern in accordance with a patterning operation. Furthermore, since the patterning data 91 is corrected by the patterning data generating apparatus 31 in accordance with the correct rule data block 913a (in other words, in accordance with the patterning condition of the patterning section 3), it is possible to easily generate the corrected data 93 and further increase the efficiency of designing a pattern.

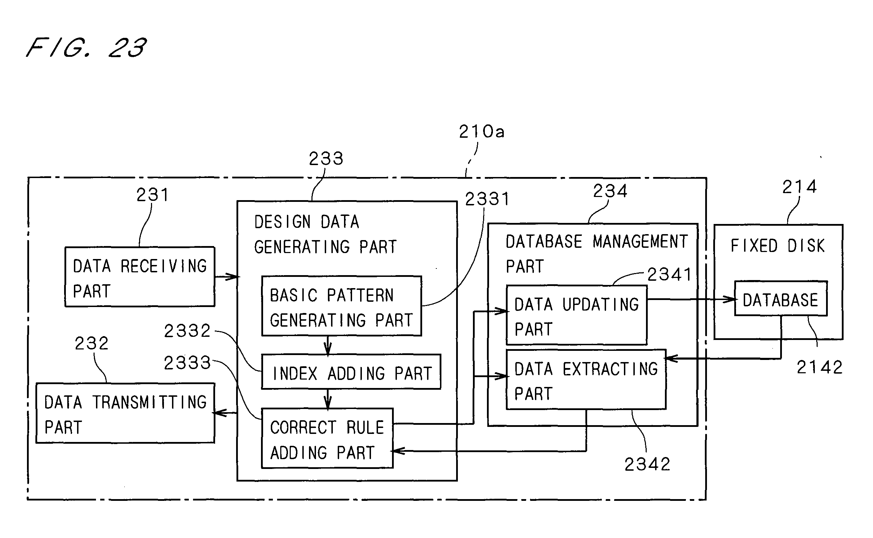

Fig. 23 is a block diagram showing functions of a basic pattern generating apparatus in a data generating system in accordance with the second preferred embodiment, together with other constitution. The data generating system of the second preferred embodiment has almost the same constitution as shown in Fig. 1 but is different from the system of Fig. 1 in that the basic pattern generating apparatus 21 implements functions surrounded by the one-dot chain line 210a in Fig.23, instead of the functions surrounded by the one-dot chain line 210 in Fig. 3, and a fixed disk 214 in the basic pattern generating apparatus 21 stores a database 2142. The patterning data generating apparatus 31 in the data generating system of the second preferred embodiment has the same constitution and functions as shown in Figs. 2 and 3, which are represented by the same reference signs in the following discussion.

As shown in Fig. 23, the design data generating part 233 has the basic pattern generating part 2331, an index adding part 2332 and a correct rule adding part 2333 as functions implemented by the CPU or the like in the basic pattern generating apparatus 21 and a database management part 234 has a data updating part 2341 and a data extracting part 2342.

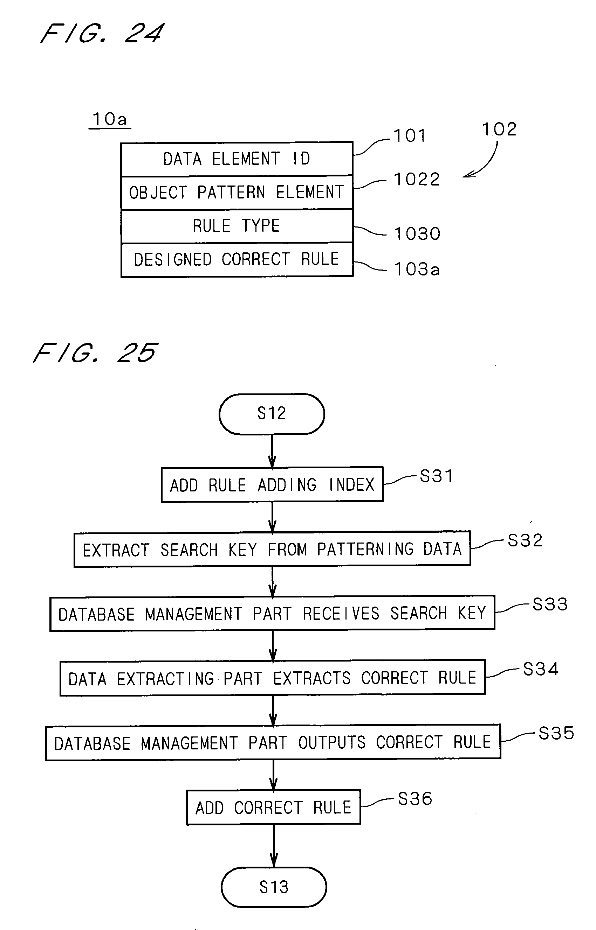

The database 2142, like the database 3142 (see Fig. 4) stored in the fixed disk 314 of the patterning data generating apparatus 31, is a set of the data elements 10a shown in Fig. 24, and each data element 10a includes the data element ID 101 for identification of the data element, the key information 102 for retrieving data elements, a correct rule (hereinafter, referred to as " designed correct rule") 103a, such as a design rule of the basic pattern associated with the key information, which is used for correction of the basic pattern in a stage of designing a pattern, regardless of the properties of the patterning facility 32 (see Fig. 1), and the rule type 1030 which is an identifier indicating the type of designed correct rule 103a. The key information 102 include the object pattern element 1022 which is an identifier indicating the type of pattern element or the type of combination of pattern elements such as devices and wires in a pattern, to which the designed correct rule 103a is applied.

Fig. 25 is a flowchart showing part of an operation flow of the data generating system in accordance with the second preferred embodiment. In the data generating system of the second preferred embodiment, operations of Steps S31 to S36 of Fig. 25 are performed by the basic pattern generating apparatus 21 between Steps S12 and S 13 in the operation of the data generating system 1 shown in Fig. 6A. In the data generating system of the second preferred embodiment, like in the first preferred embodiment, the patterning data, the corrected data and the final data on which the width compensation of wires in the basic pattern of Fig. 7 is made are generated. The operation of the data generating system of the second preferred embodiment will be discussed below, referring to Figs. 23 to 25 and other figures. Discussion on the operations before and after Steps S31 to S36 of Fig. 25 (i.e., Steps S11 and S12 of Fig. 6A, Step S13 of Fig. 6A and Steps S21 to S30 of Fig. 6B) will be simplified since the operations are the same as those of the data generating system 1 of the first preferred embodiment.

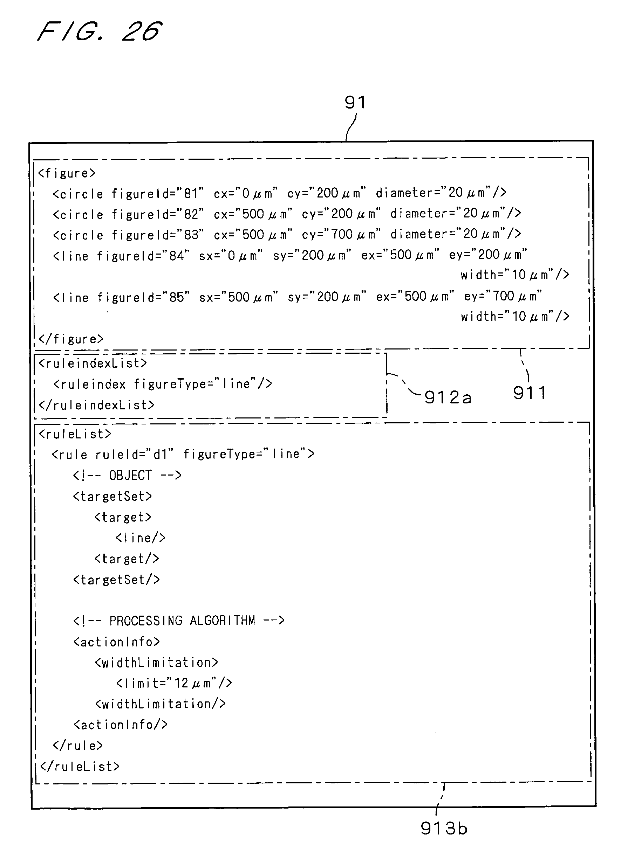

In the data generating system of the second preferred embodiment, first, the basic pattern CAD data 90 (see Fig. 8) is received by the basic pattern generating apparatus 21 and the basic pattern generating part 2331 converts the description format of the basic pattern CAD data 90 into XML, to generate the patterning data 91 (see Fig. 9) having the basic pattern data block 911 (Fig. 6A: Steps S11 and S12). Subsequently, the object pattern element 1022 to which the designed correct rule 103a is to be applied is received by the data receiving part 231 of the basic pattern generating apparatus 21 and transmitted to the design data generating part 233 and then added to the patterning data 91 as the rule adding index 912a by the index adding part 2332 as shown in Fig. 26 (Step S31). Next, the correct rule adding part 2333 extracts the object pattern element 1022 from the patterning data 91 and the extracted object pattern element serves as a search key for retrieving the designed correct rule 103a from the database 2142 (Step S32).

The search key extracted by the correct rule adding part 2333 is received by the data extracting part 2342 of the database management part 234 (Step S33). In the basic pattern generating apparatus 21, the data extracting part 2342 searches the database 2142 on the basis of the search key, and the designed correct rule 103a and the rule type 1030 which are associated with the key information 102 including the search key are extracted from the database 2142 (Step S34).

The extracted designed correct rule and the extracted rule type are outputted to the correct rule adding part 2333 of the design data generating part 233 by the database management part 234, to complete acquisition of the designed correct rule 103a (Step S35). The designed correct rule 103a which acquired thus, together with the corresponding rule type 1030 and the object pattern element 1022, is added to the patterning data 91 before being transmitted to the patterning data generating apparatus 31 by the correct rule adding part 2333 as a designed correct rule data block 913b as shown in Fig. 26 (Step S36). The patterning data 91 to which the designed correct rule 103a is added is transmitted to the patterning data generating apparatus 31 (see Fig. 1) through the communication network 9 by the data transmitting part 232 of the basic pattern generating apparatus 21 (Fig. 6A: Step S 13).

After the patterning data 91 is received by the patterning data generating apparatus 31, like in the first exemplary case, the rule adding index 912 (see Fig. 13) is added to the patterning data by the constitution of Fig. 3 (Fig. 6B: Step S21), to acquire a correct rule 103 shown in Fig. 4 (for distinguishment from the designed correct rule 103a, hereinafter, referred to as "a patterning correct rule 103") (Step S22).

The acquired patterning correct rule 103 is added to the patterning data 91 as a correct rule data block 913 (see Fig. 13: hereinafter, referred to as "a patterning correct rule data block 913" for distinguishment from the designed correct rule data block 913b), and after a correction value is acquired as necessary, the basic pattern data block 911 of the patterning data 91 is corrected with the designed correct rule 103a of the designed correct rule data block 931b and the patterning correct rule 103 of the patterning correct rule data block 913, to generate the display data 92 (see Fig. 15) (Steps S23 to S25). Subsequently, the display data 92 is transmitted to the data output part 332 and displayed on the display 315 (see Fig. 2), and appearances of the basic pattern 8, the corrected pattern 8a and the amount of correction 8b are checked (Steps S26 and S27).

If the corrected pattern 8a does not have a desired shape, the patterning correct rule data block 913 is changed independently of the basic pattern data block 911 and the designed correct rule data block 913b (Step S271), and the corrected pattern 8a and the like are displayed on the display 315 (Steps S25 and S26). When the corrected pattern 8a gets the desired shape (Step S27), the basic pattern data block 911 of the patterning data 91 is collectively corrected in accordance with the designed correct rule 103a and the patterning correct rule 103 by the corrected data generating part 3333, to generate the corrected data 93 (Step S28).

In the data generating system of the second preferred embodiment, when the corrected data 93 is generated by the patterning data generating apparatus 31, the account information part 335 gives information that the patterning data generating apparatus 31 was used and the server 22 in the design section 2 updates the accounting information in the patterning section 3, and after that, the final data is generated on the basis of the corrected data 93 (Steps S29 and S30). The information on use of the patterning data generating apparatus 31 which is made by the account information part 335 may be given in generation of the final data, instead of or besides in generation of the corrected data 93.

As discussed above, in the data generating system of the second preferred embodiment, since the basic pattern generating apparatus 21 adds the designed correct rule 103a to the basic pattern data block 911 in the design section 2, part of correction for the basic pattern 8 (in other words, the designed correct rule 103a irrelevant to the patterning condition) can be managed in the design section 2. As a result, it is possible to appropriately generate the corrected data 93 and the final data which satisfy the limitations on design (i.e., the designed correct rule 103a and the patterning correct rule 103), both in the design section 2 and the patterning section 3. Since the designed correct rule 103a is described separately from the basic pattern data block 911, the intention for correction in the design section 2 can be easily understood in the patterning section 3.

In the data generating system of the second preferred embodiment, like in the data generating system 1 of the first preferred embodiment, the patterning data 91 in which the patterning correct rule data block 913 is added to the basic pattern data block 911 is automatically generated. In the patterning data 91, since the basic pattern and the correct rule in patterning can be individually specified, it is possible to increase the efficiency of designing a pattern and easily perform a fine change of a pattern. Further, since the patterning data 91 is corrected in accordance with the patterning condition in the patterning section 3 to easily generate the corrected data 93, it is possible to increase the efficiency of designing a pattern.

Though the preferred embodiments of the present invention have been discussed above, the present invention is not limited to the above-discussed preferred embodiments, but allows various variations.

The patterning data 91, the display data 92 and the corrected data 93, for example, may be described in markup language such as SGML (Standard Generalized Markup Language) and HTML (Hyper Text Markup Language) or page description language such as PostScript, or may be described in other various description languages.

From the viewpoint of simplification of data handling, though it is preferable that data blocks of the patterning data 91, the display data 92 and the corrected data 93 (for example, the basic pattern data block 911, the rule adding index 912 and the correct rule data block 913 of the patterning data 91) should be described in the same description language, these data blocks may be described in individual description languages or description formats for easy data handling in accordance with the respective contents. There may be a case, for example, where the correct rule data block 913 is described in XML and in the basic pattern data block 911, the identifier and the name indicating the type of pattern element are described in binary and ASCII codes, respectively.

In the data generating system, if data capacity of the patterning data 91 becomes large (for example, the number of pattern elements included in the basic pattern 8 are large and so on), there may be a case where only the identifier indicating the type of correct rule (i.e., "ruleId") is added to the patterning data 91 as the correct rule data block 913 or 913a or the designed correct rule data block 913b and the correct rules corresponding to "ruleId" are sequentially called up on a memory from the database 3142 or 2142 while the basic pattern data block 911 is corrected. The correct rule 103 to be added to the patterning data 91 is not necessarily limited to one extracted from the database 3142 but may be one that is directly inputted by an operator through the input part 316. The same applies to the designed correct rule 103a to be added in the basic pattern generating apparatus 21 of the data generating system of the second preferred embodiment.

If no check on the corrected pattern is performed in the patterning data generating apparatus 31 of the data generating system, the operations in Steps S25 to S27 (generation of the display data, display of the pattern shape and check of the corrected pattern) of Fig. 6B may be omitted.

In the data generating system, the function which corresponds to the patterning data generating part 333 in the patterning data generating apparatus 31 may be implemented by other data generating apparatus provided on the communication network 9. In this case, in the patterning section 3, an operator uses the patterning data generating apparatus 31 as a terminal to make access to above-discussed other data generating apparatus through the communication network 9 and thereby generate the corrected data 93 and the final data. Management, update and the like of the database 3142 stored in the fixed disk 314 of the patterning data generating apparatus 31 are made in the patterning section 3.

In the data generating system, the server 22 which performs management of the accounting information may be provided and managed in a section other than the design section 2. If the design section 2 and the patterning section 3 are the same company and accounting management is not needed, the server 22 and the account information part 335 in the patterning data generating apparatus 31 may be omitted.

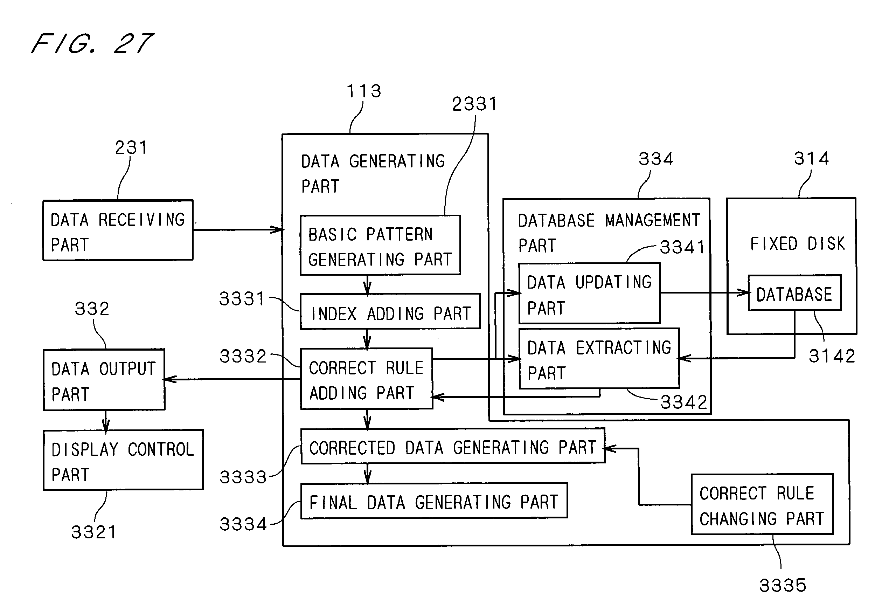

The functions implemented by the basic pattern generating apparatus 21 and the patterning data generating apparatus 31 connected to the communication network 9 in the data generating system may be implemented by a single data generating apparatus. Fig. 27 is a block diagram showing functions of the above data generating apparatus and other constitution. In Fig. 27, the same functions and constituent elements as those in the data generating system 1 of Fig. 3 are represented by the same reference signs.

The data generating apparatus has a data generating part 113 for generating the patterning data or the like and the database management part 334 for managing the database 3142 stored in the fixed disk 314. The data generating part 113 has the basic pattern generating part 2331, the index adding part 3331, the correct rule adding part 3332, the corrected data generating part 3333, the final data generating part 3334 and the correct rule changing part 3335, and the database management part 334 has the data updating part 3341 and the data extracting part 3342.

In the data generating apparatus, like in the data generating system 1, the basic pattern CAD data 90 (see Fig.8) is received by the data receiving part 231, and the patterning data 91 (see Fig. 13) having the basic pattern data block 911, the rule adding index 912 and the correct rule data block 913 which are described in XML is generated by the data generating part 113 and the database management part 334. Subsequently, the display data 92 (see Fig. 16) is generated and transmitted to the data output part 332 and its pattern shape is displayed on a display of the data generating apparatus under control by the display control part 3321. After the correct rule data block 913 is changed as necessary, the basic pattern data block 911 is corrected in accordance with the correct rule in the correct rule data block 913, to generate the corrected data 93 (see Fig. 18), and then the final data is generated on the basis of the corrected data 93.

While the invention has been shown and described in detail, the foregoing description is in all aspects illustrative and not restrictive. It is therefore understood that numerous modifications and variations can be devised without departing from the scope of the invention.

## Claims

1. A data generating system for generating patterning data used for forming a geometric pattern on a substrate in manufacturing a printed circuit board, a semiconductor substrate or a flat panel display, comprising:
a basic pattern generating part (2331) for generating data indicating a basic pattern (8) which is a group of pattern elements arranged on a substrate, to generate patterning data (91) having said data as a basic pattern data block (911); and
a correct rule adding part (3332) for adding a correct rule data block (913) to said patterning data (91), said correct rule data block (913) indicating a correct rule (103) which is obtained in a patterning operation in accordance with a type of pattern element or a type of combination of pattern elements included in said basic pattern (8).

2. The data generating system according to claim 1, further comprising
a correct rule changing part (3335) for changing a correct rule (103) indicated by said correct rule data block (913) independently of said basic pattern data block (911).

3. The data generating system according to claim 1 or 2, wherein
said correct rule data block (913) is added by said correct rule adding part (3332) as a data block described in said patterning data (91), independently of said basic pattern data block (911).

4. The data generating system according to any one of claims 1 to 3, further comprising
a storage part (314) for storing a database (3142) which is a set of data elements (10) each associating a correct rule (103) with key information (102) including a type of pattern element or a type of combination of pattern elements and a patterning condition (1021),
wherein said correct rule adding part (3332) extracts a correct rule (103) associated with key information (102) including a type of pattern element or a type of combination of pattern elements included in said basic pattern (8) and a patterning condition (1021) determined in advance from said database (3142) and adds said correct rule (103) to said patterning data (91).

5. The data generating system according to any one of claims 1 to 4, further comprising
a corrected data generating part (3333) for generating data (93) of a corrected pattern (8a) for patterning, by specifying one out of pattern elements or combinations of pattern elements which are indicated by said basic pattern data block (911), which is associated with a correct rule (103) indicated by said correct rule data block (913) and correcting a specified pattern element or a specified combination of pattern elements in accordance with said correct rule (103).

6. The data generating system according to any one of claims 1 to 5, further comprising
an output part (332) for generating data (92) of a corrected pattern (8a) for display by specifying one out of pattern elements or combinations of pattern elements which are indicated by said basic pattern data block (911), which is associated with a correct rule (103) indicated by said correct rule data block (913) and correcting a specified pattern element or a specified combination of pattern elements in accordance with said correct rule (103), and outputting difference between said basic pattern (8) and said corrected pattern (8a) with said basic pattern (8) or said corrected pattern (8a) for display.

7. A data generating system for generating patterning data used for forming a geometric pattern on a substrate in manufacturing a printed circuit board, a semiconductor substrate or a flat panel display, comprising:
a basic pattern generating apparatus (21) managed by a design section (2) for a pattern, for generating data indicating a basic pattern (8) which is a group of pattern elements arranged on a substrate, to generate patterning data (91) having said data as a basic pattern data block (911); and
a patterning data generating apparatus (31) managed by a patterning section (3) for said pattern, for adding a correct rule data block (913) to said patterning data (91) received from said basic pattern generating apparatus (21) through a communication network (9) and generating data (93) of a corrected pattern (8a),
wherein said basic pattern generating apparatus (31) comprises
a correct rule adding part (3332) for adding a correct rule data block (913) to said patterning data (91), said correct rule data block (913) indicating a correct rule (103) which is obtained in a patterning operation in accordance with a type of pattern element or a type of combination of pattern elements included in said basic pattern (8); and
a corrected data generating part (3333) for generating data (93) of a corrected pattern (8a) for patterning, by specifying one out of pattern elements or combinations of pattern elements which are indicated by said basic pattern data block (911), which is associated with a correct rule (103) indicated by said correct rule data block (913) and correcting a specified pattern element or a specified combination of pattern elements in accordance with said correct rule (103).

8. The data generating system according to claim 7, wherein
said basic pattern generating apparatus (21) further comprises another correct rule adding part (2333) for adding another correct rule (103a) used for correction of said basic pattern (8) to said patterning data (91) before being transmitted to said patterning data generating apparatus (31).

9. A patterning data generating apparatus for generating patterning data used for forming a geometric pattern on a substrate in manufacturing a printed circuit board, a semiconductor substrate or a flat panel display, comprising:
a correct rule adding part (3332) for adding a correct rule data block (913) to patterning data (91) which has data indicating a basic pattern (8) which is a group of pattern elements arranged on a substrate as a basic pattern data block (911), said correct rule data block (913) indicating a correct rule (103) which is obtained in a patterning operation in accordance with a type of pattern element or a type of combination of pattern elements included in said basic pattern (8); and
a corrected data generating part (3333) for generating data (93) of a corrected pattern (8a) for patterning, by specifying one out of pattern elements or combinations of pattern elements which are indicated by said basic pattern data block (911), which is associated with a correct rule (103) indicated by said correct rule data block (913) and correcting a specified pattern element or a specified combination of pattern elements in accordance with said correct rule (103).

10. The patterning data generating apparatus according to claim 9, further comprising
a storage part (314) for storing a database (3142) which is a set of data elements (10) each associating a correct rule (103) with key information (102) including a type of pattern element or a type of combination of pattern elements and a patterning condition (1021),
wherein said correct rule adding part (3332) extracts a correct rule (103) associated with key information (102) including a type of pattern element or a type of combination of pattern elements included in said basic pattern (8) and a patterning condition (1021) determined in advance from said database (3142) and adds said correct rule (103) to said patterning data (91).

11. The patterning data generating apparatus according to claim 9 or 10, further comprising
an account information part (335) for giving information to a predetermined accounting apparatus (22) through a communication network (9) when said corrected data generating part (3333) performs a correction.

12. The patterning data generating apparatus according to claim 9 or 10, further comprising
an account information part (335) for giving information to a predetermined accounting apparatus (22) through a communication network (9) when final data for patterning is generated on the basis of data (93) of said corrected pattern (8a).

13. A method of generating patterning data used for forming a geometric pattern on a substrate in manufacturing a printed circuit board, a semiconductor substrate or a flat panel display, comprising the steps of:
a) generating data indicating a basic pattern (8) which is a group of pattern elements arranged on a substrate to generate patterning data (91) having said data as a basic pattern data block (911); and
b) adding a correct rule data block (913) to said patterning data (91), said correct rule data block (913) indicating a correct rule (103) which is obtained in a patterning operation in accordance with a type of pattern element or a type of combination of pattern elements included in said basic pattern (8).

14. The method of generating patterning data according to claim 13, further comprising the step of
extracting a correct rule (103) associated with key information (102) including a type of pattern element or a type of combination of pattern elements included in said basic pattern (8) and a patterning condition (1021) determined in advance from a database (3142) which is a set of data elements (10) each associating a correct rule (103) with key information (102) including a type of pattern element or a type of combination of pattern elements and a patterning condition (1021) between said step a) and said step b).

15. The method of generating patterning data according to claim 13 or 14, further comprising the step of
generating data (93) of a corrected pattern (8a) for patterning, by specifying one out of pattern elements or combinations of pattern elements which are indicated by said basic pattern data block (911), which is associated with a correct rule (103) indicated by said correct rule data block (913) and correcting a specified pattern element or a specified combination of pattern elements in accordance with said correct rule (103) after said step b).

16. A method of generating patterning data used for forming a geometric pattern on a substrate in manufacturing a printed circuit board, a semiconductor substrate or a flat panel display, comprising the steps of:
adding a correct rule data block (913) to patterning data (91) which has data indicating a basic pattern (8) which is a group of pattern elements arranged on a substrate as a basic pattern data block (911), said correct rule data block (913) indicating a correct rule (103) which is obtained in a patterning operation in accordance with a type of pattern element or a type of combination of pattern elements included in said basic pattern (8); and
generating data (93) of a corrected pattern (8a) for patterning, by specifying one out of pattern elements or combinations of pattern elements which are indicated by said basic pattern data block (911), which is associated with a correct rule (103) indicated by said correct rule data block (913) and correcting a specified pattern element or a specified combination of pattern elements in accordance with said correct rule (103).

17. A computer-readable storage medium carrying patterning data used for forming a geometric pattern on a substrate in manufacturing a printed circuit board, a semiconductor substrate or a flat panel display, wherein said patterning data comprises:
a basic pattern data block (911) indicating a basic pattern (8) which is a group of pattern elements arranged on a substrate; and
a correct rule data block (913) indicating a correct rule (103) which is obtained in a patterning operation in accordance with a type of pattern element or a type of combination of pattern elements included in said basic pattern (8).

18. The storage medium according to claim 17, wherein
said correct rule data block (913) in said patterning data (91) includes a correct rule (103) intrinsic to a facility (32) used for patterning.

19. The storage medium according to claim 17 or 18, wherein
an identifier (1022) indicating a type (1030) of correct rule (103), or a type of pattern element or a type of combination of pattern elements to which a correct rule (103) is applied is added to a correct rule (103) in said correct rule data block (913).

20. The storage medium according to any one of claims 17 to 19, wherein
said basic pattern data block (911) and said correct rule data block (913) in said patterning data (91) are described in the same description language.

21. The storage medium according to claim 20, wherein
said basic pattern data block (911) and said correct rule data block (913) in said patterning data (91) are described in a markup language or a page description language.

22. The storage medium according to any one of claims 17 to 21, wherein
said basic pattern data block (911) and said correct rule data block (913) in said patterning data (91) are described as separate data blocks.

23. The storage medium according to any one of claims 17 to 22, wherein
said correct rule data block (913) in said patterning data (91) includes a correct rule (103) for correcting the width of a wire in a pattern in accordance with the length of said wire.
